# EUROPEAN PATENT APPLICATION

(11) **EP 3 258 748 A1**
(43) Date of publication of application: **20.12.2017**
(21) Application number: 16174167.3
(22) Date of filing: 13.06.2016
(51) Int. Cl.: H05B 37/02, H05B 33/08, H01L 25/16

(54) **PACKAGE OF LIGHT EMITTING DIODES**

(71) Applicant: Melexis Technologies NV, 3980 Tessenderlo (BE)
(72) Inventor: BENDER, Michael, 99092 Erfurt (DE); FREITAG, Thomas, 99338 Plaue (DE)
(74) Representative: DenK iP

(57) **Abstract**

The present invention relates to a light emitting diode, LED, package (3) comprising
- a first LED of a first colour, a second LED of a second colour and a third LED of a third colour,
- an integrated circuit (2) comprising a control circuit arranged for generating a signal to control based on control information data each of said LEDs at least in light intensity,
- a communication interface (6) comprising a data reception circuit for receiving said control information data and for forwarding said control information data to said integrated circuit.

## Description

### Field of the invention

The present invention is generally related to the field of light emitting devices. More in particular it relates to light emitting devices for use in automotive applications.

### Background of the invention

Ambient lighting in automotive applications is nowadays achieved by providing a plurality of three-colour-light emitting diodes (LEDs) located in several positions in the car. Each of the LEDs is individually controlled in intensity and colour by one integrated circuit (IC). The IC is capable of regulating the LED over its lifetime so that, for example, aging effects are compensated for. Further the IC can compensate changes of light intensity per LEDs caused by a change in the ambient temperature.

In today's applications the ambient lighting functionality is assembled on a single Printed Circuit Board (PCB), which requires a certain amount of space. For some applications it requires too big a space, especially if LEDs (and their controlling units) are very close to one another.

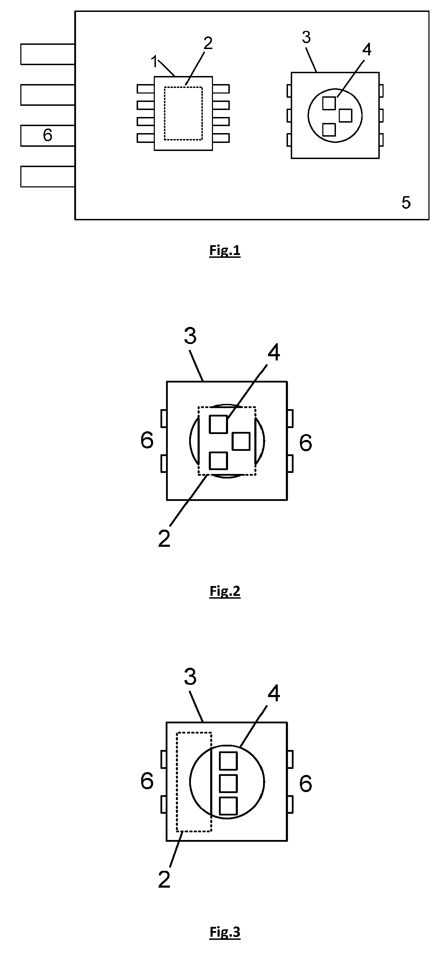

Fig.1 illustrates a prior art solution. A housing contains the following elements. A Printed Circuit Board (PCB) (5) carries a connection interface (6) which has in most applications four pins to the outside world (V_{DD}, V_{SS}, Serial Communication Input, Serial Communication Output). Other connection interfaces may have three pins for V_{DD}, V_{SS}, Serial Bus Communication, respectively. On the PCB (5) there is a package (1) carrying the integrated Circuit (IC). This IC (2) is interconnected to the 3-Colour-LED (3). The 3-Color-LED (3) is implemented as package, which contains three single LEDs in different colours (4).

The controlling of LEDs is for example described in application EP2854483, which discloses an illumination device comprising a plurality of LEDs of various colours and drivers. The device comprises a number of switches/regulators interconnected in a circuit. The switches are part of a driver. An associated controller takes care of aperiodically and independently opening and closing the switch or regulator. The controller generates a variety of PCM signals, each corresponding to a respective colour of the plurality of LEDs of different colours.

Packages are available on the market wherein laser diodes are integrated with a driver.

In US7598681 B2 is disclosed an integrated circuit to control at least one illumination source. The integrated circuit includes a clock generating circuit coupled to a data reception circuit for extracting information from serial data input to the integrated circuit in coordination with a clock pulse generated by the clock generating circuit. An illumination control signal generation circuit generates at least one illumination control signal to control the at least one illumination source based on the extracted information.

Hence, there is a need for reducing the required space while maintaining at least the same functionalities and keeping the cost at an acceptable (low) level.

### Summary of the invention

It is an object of embodiments of the present invention to provide for a LED device requiring less space while still offering the same functionality as state or the art devices.

The above objective is accomplished by the solution according to the present invention.

In a first aspect the invention relates to a light emitting diode, LED, package comprising
- a first LED of a first colour, a second LED of a second colour and a third LED of a third colour,
- an integrated circuit comprising a control circuit arranged for generating a signal to control, based on control information data, each of said LEDs at least in light intensity,
- a communication interface comprising a data reception circuit for receiving said control information data and for forwarding said control information data to said integrated circuit.

The proposed solution indeed allows reducing the required space. Due to bringing the three LEDs, the integrated circuit and the interface together in a single package, a considerable gain is achieved. This does not impede the integrated circuit from having the usual functionalities. In other words, a further integration is achieved without compromising the performance.

In a preferred embodiment the LEDs are mounted on the integrated circuit. Alternatively, the LEDs are mounted side-by-side to the integrated circuit.

In a preferred embodiment the integrated circuit is programmable. The integrated circuit is preferably arranged for programming the LEDS in terms of light intensity per colour in a calibration procedure.

In one embodiment the integrated circuit comprises a temperature sensing unit. In another embodiment the integrated circuit comprises a current and/or voltage sensing unit.

In another embodiment the signal generated by the control circuit also controls, based on said control information data, each of the LEDs in terms of colour temperature.

In an embodiment the first colour is red, the second colour green and the third colour blue. Obviously any other colour can be applied.

In a preferred embodiment the communication interface is a serial interface. Advantageously, the communication interface is a Local Interconnect Network.

In one embodiment the integrated circuit comprises a communication network wherein the LEDs are connected with each other in a daisy chain topology.

In yet another embodiment the first, the second and the third LED are part of a LED matrix.

In another aspect the invention relates to a network of LED packages as previously described.

In another embodiment the integrated circuit of at least one of said LED packages is arranged for detecting its location in said network via said communication network of said network.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates a prior art solution.
Fig.2 illustrates a LED package according to an embodiment of this invention.
Fig.3 illustrates a side-by-side construction to form the interconnections between the LEDs.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention proposes a LED package integrating a control integrated circuit (IC) and three LEDs forming a 3-colour LED device. This integration saves a substantial amount of space as compared to a conventional implementation on a printed circuit board.

Fig.2 illustrates an embodiment of the LED package according to the invention. A package (3) contains the controlling IC (2). On top of the controlling IC there are three LEDs (4) mounted to build up the 3-Color-Function. The package has a connection interface 6, which has in a typical embodiment four pins to the outside world (supply voltage V_{DD}, ground voltage V_{SS}, Serial Communication Input, Serial Communication Output). In another embodiment the communication interface 6 has three pins (V_{DD}, V_{SS}, Serial Communication). In yet other embodiments the communication interface 6 also can have more pins.

In one embodiment the mounting of the LEDs on top of the IC can be realised in a Transfer Printing Technology as described for instance in US2016/016399 A1. The LEDs nor the controlling IC can be manufactured in a monolithic manner and remain therefore as separate units. The transfer printing technology describes how the LEDs can be picked up from a substrate and mounted on the surface of the controlling IC in a reliable manner. Interconnections between the LEDs and the controlling IC can be achieved with bonding technologies or with an additional metallization layer, which is structured with structuring processing steps in order to form the interconnections. Another option is for instance a side by side construction as shown in Fig. 3.

The integrated circuit is preferably programmable. During an initial calibration procedure the LED-device may be programmed to a specified light intensity and colour temperature. This is done by programming the current of each LED inside the LED-device, e.g. by setting an analogue current value or by setting a PWM frequency/PWM ratio depending on the used controlling method. This also reduces the influence of so called "binning" of the used LEDs in the LED-device, so that initial tolerances of each used LED inside the LED-device are reduced. Furthermore some maximum/minimum parameters (e.g. current or temperature) can be programmed, indicating in which range the device should work. If the device operates outside this range, an error signal might be generated, which can later be used for diagnostic functions. This is particularly useful when calibrating the LEDs at the beginning of their life cycle in order to define light intensity per colour.

One of the common tasks of the IC is to regulate aging effects of the LED by providing compensation during the life cycle of the LED. It is known that LEDs over their lifetime may change their output behaviour in light intensity and also in colour spectrum. Out of the characterization data of each used LED, compensation methods might be applied, which consider the operational time, temperature, applied current and measured voltage on each LED of the LED-device. The compensation method mainly acts on the applied current in order to keep the light intensity/colour temperature within the specified range. The IC further needs to compensate changes of light intensity per LED caused by changes of the ambient temperature

Via the communication interface the integrated circuit receives control information for the light intensity and/or colour temperature from a higher level system. For instance the LED-devices can completely be switched on or off, or the LED-device can generate light in the complete colour temperature range and intensity by adjusting the current in the LEDs of the LED-device. If the LED-devices are operating in a network configuration, different light scenarios are possible.

In a preferred embodiment the communication interface is a serial interface, e.g. a Local Interconnect Network (LIN) network. In other embodiments other serial interfaces employing any other suitable communication protocol are employed.

The Local Interconnect Network (LIN) bus standard is an open protocol defined for use in communicating between a set of distributed modules. Such communication standard may typically refer to systems in which a plurality of similar modules are used on a common bus line, and in which each module may need to be addressed individually. A LIN bus system may comprise a master node that is connected via a wired connection, e.g. by a single data wire forming a common signal conductor, to at least one slave node. Thus, the master node and slave node(s), connected by the data wire, form a network cluster. These slave devices may form control components associated with identical and/or different functions to be controlled by the master device. For example, such functions that can be controlled by a LIN data bus system, as known in the art for automotive applications, are window lifting, seat heating, motor control or power generation.

The communication via the serial interface can be unidirectional so that control information for the light setting can be transferred from a controlling unit to each light source. It can also be bidirectional, e.g. if the light source transfers diagnostic information back to the controlling unit. In a LIN network implementation the controlling unit is a LIN master device that receives information from and transmits information to each LIN slave. In this specific implementation all light sources connected to the LIN-Master-Device are LIN slaves.

In one embodiment the IC is provided with intelligence in order to detect its physical local position in the network at a first initialization of the network. In this network realization the communication output of the first LED light source is connected to the communication input of the second LED light source. The communication output of the second light source is connected to the communication input of the third light source and so on (daisy chain topology). In order to give the controlling unit (or the LIN-Master-Device in a LIN network realization) the opportunity to address and to control each light source individually, each light source needs to have an individual address. In a daisy chain configuration this individual address is provided in a calibration sequence after power on: The first light source gets a unique address from the controlling unit. After that the second light source gets the unique address and so on. After terminating the calibration process, the controlling unit (or the LIN master-device in a LIN network-realization) can address and control each light source individually.

Advantageously the IC is capable of performing some diagnostic functions, which are used on local level for LED calibration purposes or in order to provide status information to the higher level system via the communication interface.

In a typical embodiment the integrated circuit contains a temperature sensing unit in order to regulate out temperature effects on the light intensity and/or colour temperature. In another embodiment the integrated circuit contains a current and/or voltage sensing unit to detect currents and/or voltages on one or more of the LEDs. The temperature sensing unit and the current/voltage sensing unit can be integrated in the integrated circuit.

As a LIN network is limited in its specification to maximum 16 nodes, an architectural solution is possible wherein the three LEDs and the controlling IC are integrated into the LED package., whereby the controlling IC has a LIN Slave Function to control the light sources and additionally a master function, whereon another LIN sub-network with maximum 16 members can be connected. In that case the connection interface (6) contains either 6 pins (V_{DD}, V_{SS}, Serial Communication Input 1, Serial Communication Output 1, Serial Communication Input 2, Serial Communication Output 2) or 4 pins (V_{DD}, V_{SS}, Serial Communication 1 and Serial Communication 2).

The invention offers several advantages. The PCB as carrier is rendered obsolete, which saves space and reduces costs. This opens the door for addressing applications with space constraints, e.g. in the field of automotive ambient lighting. Another major advantage is that the integration is possible without giving anything up in terms of control functionality.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Light emitting diode, LED, package (3) comprising
- a first LED of a first colour, a second LED of a second colour and a third LED of a third colour,
- an integrated circuit (2) comprising a control circuit arranged for generating a signal to control, based on control information data, each of said LEDs at least in light intensity,
- a communication interface (6) comprising a data reception circuit for receiving said control information data and for forwarding said control information data to said integrated circuit.

2. LED package as in claim 1, wherein said LEDs (4) are mounted on said integrated circuit.

3. LED package as in claim 1, wherein said LEDs (4) are mounted side-by-side to said integrated circuit.

4. LED package as in any of claims 1 to 3, wherein said integrated circuit is programmable.

5. LED package as in claim 4, wherein said integrated circuit is arranged for programming said LEDs in terms of light intensity per colour.

6. LED package as in any of claims 1 to 5, wherein said integrated circuit comprises a temperature sensing unit.

7. LED package as in any of the previous claims, wherein said integrated circuit comprises a current and/or voltage sensing unit.

8. LED package as in any of the previous claims, wherein said signal generated by said control circuit also controls, based on said control information data, each of said LEDs in colour temperature.

9. LED package as in any of the previous claims, wherein said first colour is red, said second colour green and said third colour blue.

10. LED package as in any of the previous claims, wherein said communication interface is a serial interface.

11. LED package as in claim 10, wherein said communication interface is a Local Interconnect Network.

12. LED package as in any of the previous claims, wherein said integrated circuit comprises a communication network wherein said LEDs are connected with each other in a daisy chain topology.

13. LED package as in any of the previous claims, wherein said first LED, second LED and third LED are part of a LED matrix.

14. Network of LED packages as in any of the previous claims.

15. Network as in claim 14, wherein said integrated circuit of at least one of said LED packages is arranged for detecting its location in said network via said communication network of said network.
